# EUROPEAN PATENT APPLICATION

(11) **EP 4 645 391 A1**
(43) Date of publication of application: **05.11.2025**
(21) Application number: 24177101.3
(22) Date of filing: 21.05.2024
(51) Int. Cl.: H01L 29/06, H01L 29/78, H01L 29/10, H01L 29/08

(54) **SEMICONDUCTOR DEVICE**

(30) Priority: 29.04.2024 CN 202410526846
(71) Applicant: Chongqing Innoevsic Technology Co., Ltd., Chongqing 401133 (CN)
(72) Inventor: Oh, Hansu, Chongqing, 401133 (CN); Seo, Young Hun, Chongqing, 401133 (CN)
(74) Representative: Bals & Vogel Patentanwälte PartGmbB

(57) **Abstract**

The present disclosure provides a semiconductor device including a semiconductor layer and a trench gate structure. The semiconductor layer includes: a source region extending from a first surface toward a second surface; a drift region and a body region, wherein at least a part of the drift region is located between the body region and the second surface of the semiconductor layer, the body region has a first part located between the source region and the drift region; a channel drain region located between the first part of the body region and the drift region, so that the source region, the first part of the body region and the channel drain region are sequentially adjoining in a direction of the first surface toward the second surface and adjoin a first sidewall of the trench gate structure. The semiconductor device of the present disclosure has better controllability of channel length variation.

## Description

### Cross-reference to related applications

This present disclosure claims priority to a Chinese patent application No. 2024105268462, filed on April 29, 2024, and entitled "semiconductor device", the entire contents of which are incorporated herein by reference, including the specification, claims, drawings and abstract.

### FIELD OF TECHNOLOGY

The present disclosure relates to a field of semiconductor device, and in particular, to a semiconductor device having a trench gate structure.

### BACKGROUND

Compared with planar transistor structure, vertical transistor structure has an advantage of balancing a blocking voltage and an on-resistance over a same area. When the power device module or plurality of discrete devices are used at the same system, transistor device-to-device variation of characteristics is also an important factor to consider for the robustness of the integrated system. During manufacturing, transistors need to get through lots of process steps and different manufacturing tools. Accordingly, transistor device characteristics vary device by device. Characteristics of each device should be more uniform with increasing integration, wherein uniformity of a channel length is one of important components.

### SUMMARY

In view of above problems, an objective of the present disclosure is to provide a semiconductor device with configuration of channel drain region, so that the semiconductor device has better controllability of channel length variation.

A semiconductor device according to embodiments of the present disclosure includes a semiconductor layer and a trench gate structure, wherein the semiconductor layer has a first surface and a second surface opposite to each other, the trench gate structure is at least partially located in a trench on the first surface of the semiconductor layer,
the semiconductor layer includes:
a source region, extending from the first surface toward the second surface;
a drift region and a body region, wherein at least a part of the drift region is located between the body region and the second surface of the semiconductor layer, and the body region has a first part located between the source region and the drift region; and
a channel drain region, located between the first part of the body region and the drift region, so that the source region, the first part of the body region and the channel drain region are sequentially adjoining in a direction of the first surface toward the second surface and adjoin a first sidewall of the trench gate structure,
wherein the source region, the channel drain region, and the drift region are of a first conductivity type, the body region is of a second conductivity type, and the first conductivity type is opposite to the second conductivity type.

Optionally, a doping concentration of the channel drain region is greater than a doping concentration of the drift region.

Optionally, the first part, a second part and a third part of the body region are sequentially adjoining along a width direction of the trench gate structure,
the second part of the body region adjoins a second sidewall of the trench gate structure and the drift region, respectively,
the third part of the body region extends from a bottom surface of the trench gate structure toward the second surface and adjoins the drift region,
the channel drain region is separated from the third part of the body region by the drift region,
the first sidewall is opposite to the second sidewall.

Optionally, the second part of the body region includes a first sub-region and a second sub-region that are connected,
the first sub-region adjoins the first part of the body region, the second sub-region adjoins the third part of the body region,
wherein a distance from an edge of the channel drain region facing toward the second surface to the first surface is a first distance,
a distance from an edge of the first sub-region facing toward the second surface to the first surface is a second distance,
a distance from an edge of the second sub-region facing toward the second surface to the first surface is a third distance,
the third distance is greater than the first distance, the first distance is greater than the second distance, so that the channel drain region is separated from the second sub-region by the drift region along the width direction of the trench gate structure.

Optionally, edges of the second part and the third part of the body region facing toward the second surface are connected.

Optionally, a distance from an edge of the channel drain region facing toward the second surface to the first surface is a first distance,
a distance from a bottom surface of the trench gate structure to the first surface is a fourth distance,
the first distance is not greater than the fourth distance.

Optionally, a distance from an edge of the channel drain region facing toward the second surface to the first surface is a first distance,
a distance from a bottom surface of the trench gate structure to the first surface is a fourth distance,
the first distance is greater than the fourth distance, and the channel drain region adjoins a part of the bottom surface of the trench gate structure.

Optionally, the semiconductor layer further includes a body contact region extending from the first surface toward the second surface and adjoins the body region,
wherein the body contact region is of the second conductivity type.

Optionally, along an extension direction of the trench gate structure, a part of the body contact region adjoins the second sidewall, another part of the body contact region has a space from the second sidewall, and the part of the body contact region adjoining the second sidewall and the part of the body contact having a space from the second sidewall are arranged alternatively along the extension direction of the trench gate structure,
or the body contact region is separated from the second surface by the body region.

Optionally, the body contact region adjoins the source region, or the body contact region is separated from the source region by the body region.

Optionally, the trench gate structure includes a gate dielectric layer and a gate conductor,
the gate dielectric layer covers an inner surface of the trench and covers part of first surface adjacent to the trench, the trench extending from the first surface toward the second surface,
a part of the gate conductor is in the trench, another part extends outside the trench and covers the gate dielectric layer,
wherein the gate dielectric layer is located between the gate conductor and the semiconductor layer, so as to separate the gate conductor and the semiconductor layer.

Optionally, the semiconductor layer includes a SiC semiconductor layer.

Optionally, the semiconductor device is a metal-oxide semiconductor field effect transistor or an insulated gate bipolar transistor.

Optionally, between two trench gate structures, the source region extends from the first sidewall of one trench gate structure towards the second sidewall of the other trench gate structure, and adjoins the second part of the body region.

One of the above technical solutions has following beneficial effects:

By configuring the channel drain region, the first part of the body region and the source region to sequentially adjoin the same sidewall of the trench gate structure in a vertical direction, and controlling the trench length by use of the location of the channel drain region, the uniformity of the length of the channel is improved, the uniformity of an overlap region between the channel and the drain region is improved, so as to improve an overall performance of the device.

In some embodiments, the second part of the body region is divided into the first sub-region and the second sub-region in a horizontal direction. The first part of the body region, the first sub-region, and the second sub-region are sequentially adjoining. By adjusting the distance of a bottom edge of the first sub-region to the first surface of the semiconductor layer, the second sub-region of the channel drain region is separated from the body region by the drift region. In the direction along the first surface to the second surface, the distance from the first sidewall of the trench gate structure to the body region gradually increases. When the device is on, a current path of a current flow to the second surface becomes wider after the current flows through the source region, the channel and the channel drain region, so as to reduce an on-resistance and further improve the performance of the device.

In some embodiments, the gate dielectric layer extends from the inner surface of the trench to the first surface of the semiconductor layer, so as to protect a part of the trench gate structure adjoining to the first surface of the semiconductor layer.

It should be noted that the above general description and the later detailed description are only exemplary and explanatory and do not limit the present disclosure.

### BRIEF DESCRIPTION OF THE DRAWINGS

In order to more clearly explain the technical scheme of the embodiment of the present disclosure, the drawings of the embodiment will be briefly introduced below, obviously, the drawings in the following description only refer to some embodiments of the present disclosure, and shouldn't be a limitation of the present disclosure.
FIG. 1 is a schematic diagram of three-dimensional structure of a semiconductor device according to a first embodiment of the present disclosure.
FIG. 2 is a schematic diagram of top view structure of a semiconductor device according to the first embodiment of the present disclosure.
FIG. 3 is a schematic section along AA line in FIG. 2.
FIG. 4 is a schematic diagram of a semiconductor device according to a second embodiment of the present disclosure.
FIG. 5 is a schematic diagram of top view structure of a semiconductor device according to a third embodiment of the present disclosure.
FIG. 6 is a schematic section along BB line in FIG. 5.
FIG. 7 is a schematic diagram of a semiconductor device according to a fourth embodiment of the present disclosure.
FIG. 8 is a schematic diagram of a semiconductor device according to a fifth embodiment of the present disclosure.
FIG. 9 is a schematic diagram of a semiconductor device according to a sixth embodiment of the present disclosure.

### DETAILED DESCRIPTION OF THE DISCLOSURE

The present disclosure will be described in more detail below with reference to the drawings. In the drawings, the same elements are represented by similar reference marks. The sections in the drawings are not plotted to scale for clarity. In addition, some publicly known parts may not be shown. For simplicity, a semiconductor structure obtained after several processes could be described in one drawing.

It should be understood that when describing structure of a device, a layer, an area and a region called "on" or "above" another layer, another area or another region may directly on top of another layer, another area or another region, or there is other layer, area or reigon between it and another layer, another area or another region. If the device is flipped, the layer, the area or the region will be located "below" or "under" another layer, another area or another region.

In order to describe a situation that the layer or the area is directly above another layer or another area, the expressions "directly on/above ......" or "above and adjoin ......" will be used in the present disclosure.

Power device usually includes active cell area, edge termination area, and crack-stop or shielding area. Active cell area includes an array of active cells. The present disclosure is about active cell structure. Active cell size may be different by product needs and there may be a body region between active cells in an active cell area.

Many specific details of the present disclosure, such as structure, materials, dimensions, processing processes, and techniques of the device, are described below in order to provide a clearer understanding of the present disclosure. However, as those skilled in the art could understand, the present disclosure may not be limited according to these specific details.

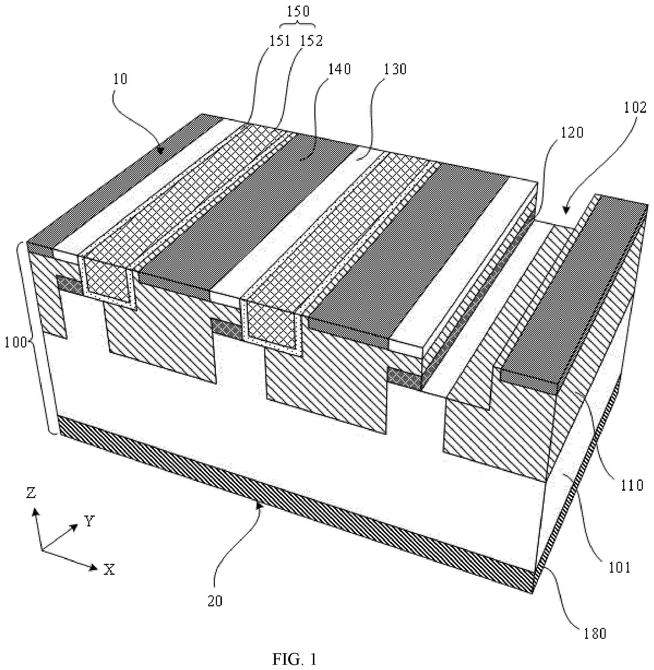

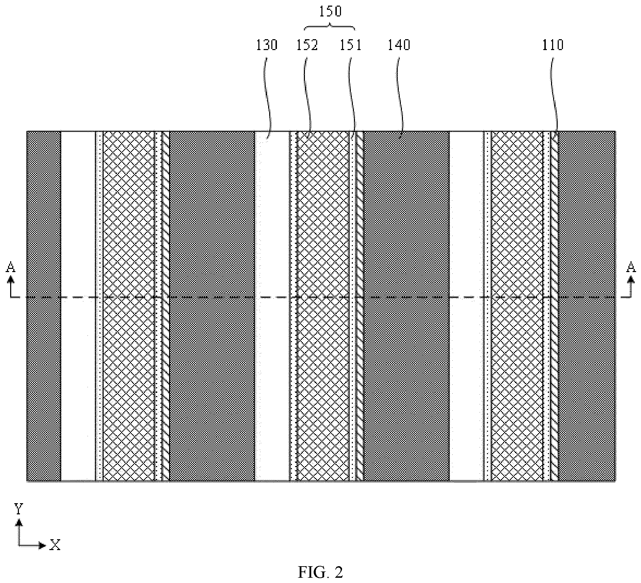

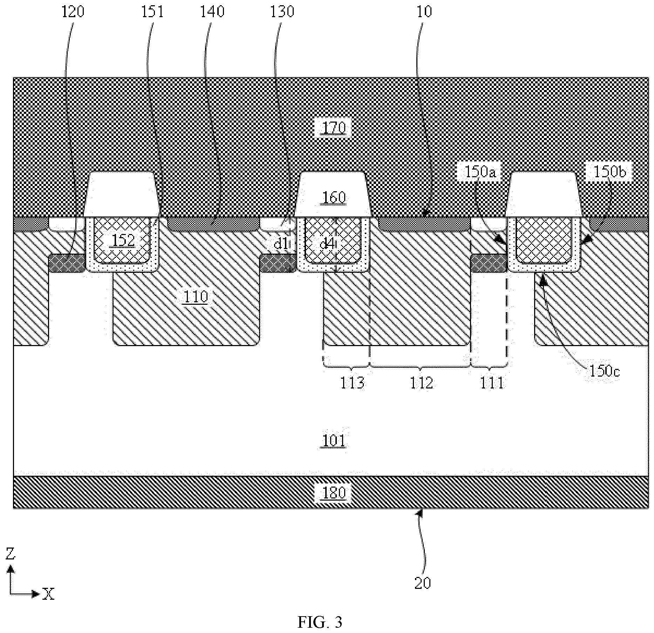

FIG. 1 is a schematic diagram of three-dimensional structure of a semiconductor device according to a first embodiment of the present disclosure. FIG. 2 is a schematic diagram of top view structure of a semiconductor device according to the first embodiment of the present disclosure. FIG. 3 is a schematic section along AA line in FIG. 2. Wherein, in order to show more clearly positional relationship between various structures and areas, structure above a semiconductor layer and a part of trench gate structure is not shown in FIG. 1, and the structure above the semiconductor layer is not shown in FIG. 2.

As shown in FIGS. 1 to 3, the semiconductor device according to the first embodiment of the present disclosure includes a semiconductor layer 100, a plurality of trench gate structures 150, an interlayer dielectric layer 160, and a source metal layer 170. The semiconductor layer 100 has a first surface 10 and the second surface 20 opposite to each other and a plurality of trenches 102, wherein the plurality of trenches 102 extends from the first surface 10 to the semiconductor layer 100 along a direction of the first surface 10 to the second surface 20. A plurality of trench gate structures 150 are located in the corresponding trenches 102. The semiconductor layer 100 is, for example, a SiC substrate or a stacked structure includes the SiC substrate and an epitaxial layer. However, the embodiments of the present disclosure are not limited to this, and those skilled in the art may configure the materials and number of layers of the semiconductor layer 100 as required.

The semiconductor layer 100 includes a drift region 101, a body region 110, a channel drain region 120, a source region 130, a body contact region 140, and a drain contact region 180. Wherein, the channel drain region 120, the source region 130 and the drift region 101 are of a first conductivity type, the body region 110 and the body contact region 140 are of a second conductivity type, and the first conductivity type is opposite to the second conductivity type. The first conductivity type is one of the P type and N type, and the second conductivity type is the other of the P type and N type. A doping concentration of the channel drain region 120 is greater than that of the drift region 101, and a doping concentration of the body contact region 140 is greater than that of the body region 110.

The semiconductor device of the present embodiment may be used as a metal-oxide semiconductor field effect transistor (MOSFET), or as an insulated gate bipolar transistor (IGBT). For example, the conductivity type of the drain contact region 180 is set to the first conductivity type or the second conductivity type accordingly. However, the embodiments of the present disclosure are not limited to this, and those skilled in the art may configure the conductivity types of various regions in the semiconductor layer 100 as required, so as to serve the semiconductor device as MOSFET or IGBT.

The trench gate structure 150 includes a gate dielectric layer 151 and a gate conductor 152. The gate dielectric layer 151 covers an inner surface of the trench 102, and the gate conductor 152 is located in the trench 102. The gate dielectric layer 151 is located between the semiconductor layer 100 and the gate conductor 152 to isolate the semiconductor layer 100 from the gate conductor 152. The trench gate structure 150 has a first sidewall 150a, a second sidewall 150b, and a bottom surface 150c, wherein the first sidewall 150a is opposite to the second sidewall 150b. The plurality of trench gate structures 150 extend along Y-axis direction (length direction of the trench gate structure 150) and are spaced disposed along X-axis direction (width direction of the trench gate structure 150). Optionally, the X-axis direction, the Y-axis direction and Z axis direction (direction of the second surface 20 to the first surface 10) are perpendicular to each other. Optionally, X-axis direction is <11-20> direction or <1-100> direction, and a plane of the first sidewall 150a and the second sidewall 150b is (11-20) plane or (1-100) plane.

The body region 110 includes a first part 111, a second part 112 and a third part 113 sequentially connected along the X-axis direction. Between two adjacent trench gate structures 150, the first part 111 adjoins the first sidewall 150a of one the trench gate structures 150, and the second part 112 and the third part 113 both adjoin another trench gate structure 150. Wherein, the second part 112 adjoins the second sidewall 150b of the trench gate structure 150, and the third part 113 is located between a bottom surface 150c of the trench gate structure 150 and the second surface 20. The third part 113 adjoins the bottom surface 150c of the trench gate structure 150. Edges of the second part 112 and the third part 113 facing toward the second surface 20 is substantially flush, so that the edges of the second part 112 and the third part 113 facing toward the second surface 20 are connected. Alternatively, the first part 111, the second part 112, and the third part 113 have different doping concentrations.

The channel drain region 120 is close to the bottom surface 150c of the trench gate structure 150, and the source region 130 extends from the first surface 10 of the semiconductor layer 100 toward the second surface 20. The first part 111 of the body region 110 is located between the channel drain region 120 and the source region 130, so that the channel drain region 120 is separated from the source region 130 by the first part 111 along the Z-axis direction. Wherein, the channel drain region 120, the first part 111 and the source region 130 are sequentially adjoining in the Z axis direction and both adjoin the first sidewall 150a of the same trench gate structure 150. The channel drain region 120 adjoins the second part 112 of the body region 110, and the channel drain region 120 is separated from the third part 113 of the body region 110 by the drift region 101. A distance d1 between an edge of the channel drain region 120 facing toward the second surface 20 and the first surface 10 is not greater than a distance d4 of the bottom surface 150c of the trench gate structure 150 to the first surface 10.

In the present embodiment, when the semiconductor device is on, a part of the first part 111 of the body region 110 that adjoins the first sidewall 150a of the trench gate structure 150 inverses, so as to form a channel. By setting the channel drain region 120 close to the bottom surface 150c of the trench gate structure 150, the channel length could be controlled accurately, thereby enhancing the uniformity of a plurality of channel lengths in the semiconductor device. Meanwhile, the uniformity of an overlap region between the channel and the drain area and the uniformity of doping concentration of the drain region is improved by setting the channel drain region 120, so as to improve an overall performance of the device.

In some specific embodiments, the channel drain region 120 is formed in the same process step as the source region 130 to facilitate precise control of the channel length and further enhance the uniformity of the channel length.

Optionally, between two trench gate structures 150, the source region 130 extends from the first sidewall 150a of one trench gate structure 150 towards the second sidewall 150b of the other trench gate structure 150, and adjoins the second part 112 of the body region110. When a junction depth of the source region 130 is deep, increasing a width of the source region 130 helps to reduce a contact diffusion resistance of the source region 130.

The body contact region 140 extends from the first surface 10 of the semiconductor layer 100 toward the second surface 20, and adjoins the body region 110. Along the X-axis direction, between two adjacent trench gate structures 150, one end of the body contact region 140 adjoins the source region 130, the other end is close to the second sidewall 150b of the trench gate structure 150 and is not connected to the second sidewall 150b. The body contact region 140 is separated from the second sidewall 150b by the body region 110.

The source metal layer 170 is located on the first surface 10 of the semiconductor layer 100 and adjoins the source region 130 and the body contact region 140, respectively. A part of the body region 110 is exposed at the first surface 10, and the source metal layer 170 further adjoins the part of the body region 110 exposed at the first surface 10. The interlayer dielectric layer 160 is located between the semiconductor layer 100 and the source metal layer 170, and is arranged corresponding to the trench gate structure 150 for separating the source metal layer 170 from the trench gate structure 150. The source metal layer 170 and the interlayer dielectric layer 160 may be multiple layers with different materials. As an example of multiple layers of the source metal, the source metal layer 170 includes W layer directly over contact region 140 and source region 130 and AlCu layer directly over W layer. The present embodiment may further include portions not shown in the figures, for example, gate conductor 152 is connected to a gate metal layer by opening a gate contact region over the gate conductor 152, the gate contact region is directly on the gate conductor 152, and the gate conductor 152 is isolated from source metal layer 170 by an interlayer dielectric layer 160.

At least part of the drift region 101 is located between the source region 130 and the second surface 20, adjacent to the second part 112, the third part 113, the channel drain region 120 of the body region 110, the trench gate structure 150 and the drain contact region 180. The drain contact region 180 extends from the second surface 20 of the semiconductor layer 100 toward the first surface 10.

Further, the semiconductor device of the present embodiment further includes a drain metal layer (not shown) located on the second surface 20 of the semiconductor layer 100, and connected to the drain contact region 180.

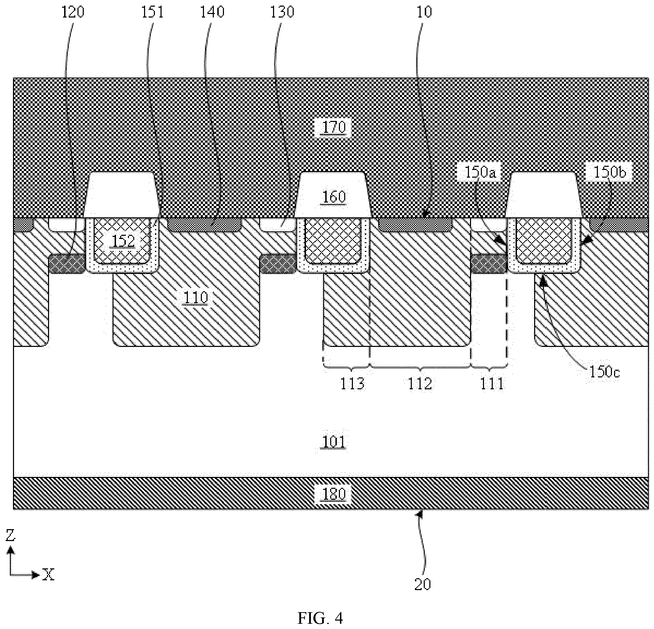

FIG. 4 is a schematic diagram of a semiconductor device according to a second embodiment of the present disclosure.

As shown in FIG. 4, the similarities between the semiconductor device of the second embodiment and the first embodiment will not be described here, with referring to FIGS. 1 to 3. The difference is that the body contact area 140 of the present embodiment is separated from the source region 130 by the body region 110.

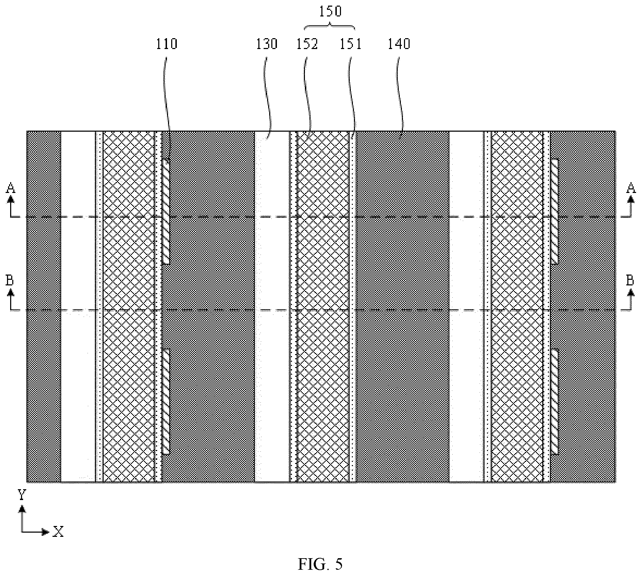

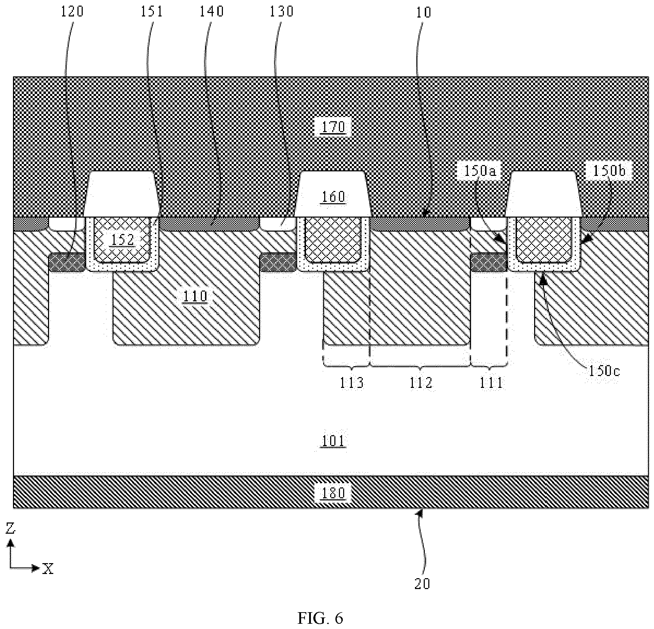

FIG. 5 is a schematic diagram of top view structure of a semiconductor device according to a third embodiment of the present disclosure. FIG. 6 is a schematic section along BB line in FIG. 5. Wherein, in order to show more clearly positional relationship between various structures and areas, structure above a semiconductor layer is not shown in FIG. 6. A schematic section along AA line in FIG. 5 could refer to FIG. 3.

As shown in FIG. 5 and FIG. 6, the similarities between the semiconductor device of the third embodiment and the first embodiment will not be described here, with referring to FIGS. 1 to 3. The difference is that, in the present embodiment, along the Y-axis direction, a part of the body contact region 140 adjoins the second sidewall 150b of the trench gate structure 150, another part of the body contact region 140 has a space from the second sidewall 150b by being isolated apart by the body region 110. Along the Y-axis direction, the part of the body contact region 140 adjoining the second sidewall 150b and the part of the body contact 140 having a space from the second sidewall 150b are arranged alternatively.

Gate to source capacitance includes three components as a capacitance of gate conductor 152 to body region 110, a capacitance of gate conductor 152 to body contact region 140 and a capacitance of gate conductor 152 to source region 130. The source region 130 is electrically connected to the body region 110. Because the doping concentration of the body contact region 140 is higher than that of body region 110, it has higher capacitance per area, so that total gate to source capacitance could be modulated by manipulating the area of the body contact region 140 that directly contacting the second sidewall 150b. Depending on the application or system requirement, requirements for gate charge or gate-to-drain capacitance/(gate-to-drain capacitance + gate-to-source capacitance) ratio can be different. For example, during the transistor turn-off with hard switching, drain voltage abruptly increases and it can leads to gate self-turn on behavior due to the capacitance coupling. If no margin in gate self-turn on, by increasing gate to source capacitance, the margin can be improved.

Alternatively, similar to the second embodiment of the present disclosure, the body contact region 140 and the source region 130 of the semiconductor device of the third embodiment may be separated.

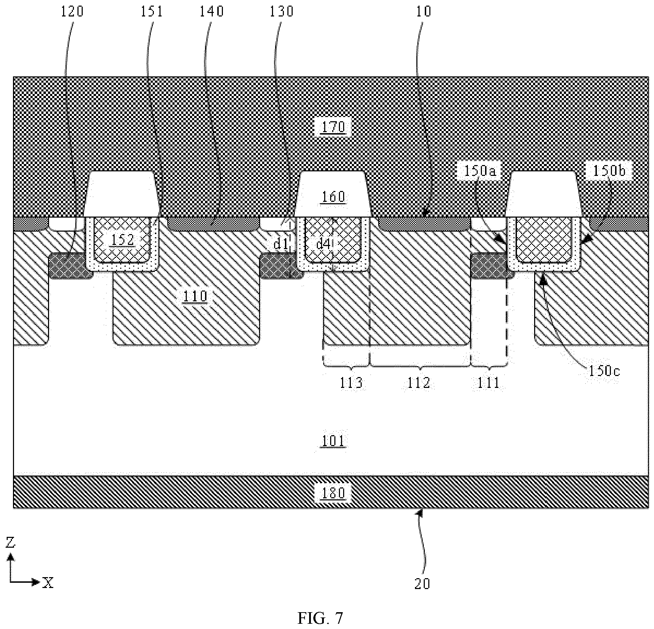

FIG. 7 is a schematic diagram of a semiconductor device according to a fourth embodiment of the present disclosure.

As shown in FIG. 7, the similarities between the semiconductor device of the fourth embodiment and the first embodiment will not be described here, with referring to FIGS. 1 to 3. The difference is that, in the present embodiment, a distance d1 of an edge of the channel drain region 120 facing toward the second surface 20 to the first surface 10 is greater than a distance d4 of the bottom surface 150c of the trench gate structure 150 to the first surface 10, and the channel drain region 120 adjoins a part of the bottom surface 150c of the trench gate structure 150, so as to match depths of different trenches 102, injection time and injection dose of the channel drain region 120.

Alternatively, similar to the second embodiment of the present disclosure, the body contact region 140 and the source region 130 of the semiconductor device of the fourth embodiment may be separated.

Alternatively, the body contact area 140 of the semiconductor device of the fourth embodiment of the present disclosure may also be configured as in the third embodiment of the present disclosure. Along the Y-axis direction, a part of the body contact region 140 adjoins the second sidewall 150b of the trench gate structure 150, another part of the body contact region 140 has a space from the second sidewall 150b by being isolated apart by the body region 110, so as to adjust characteristics related to the gate to source capacitance modulates.

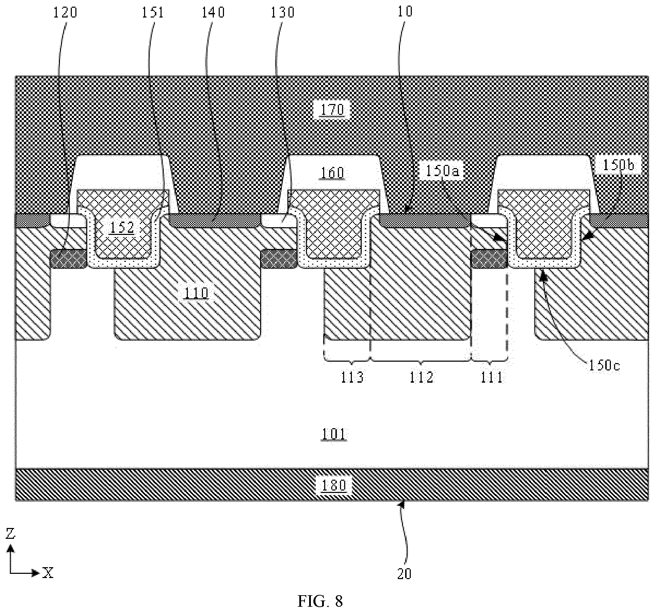

FIG. 8 is a schematic diagram of a semiconductor device according to a fifth embodiment of the present disclosure.

As shown in FIG. 8, the similarities between the semiconductor device of the fifth embodiment and the first embodiment will not be described here, with referring to FIGS. 1 to 3. The difference is that, in the present embodiment, a part of the trench gate structure 150 is located in the trench 102, and another part is located above the first surface 10. Specifically, the gate dielectric layer 151 covers an inner surface of the trench 102 and part of the first surface 10 adjacent to the trench 102, a part of the gate conductor 152 is located in the trench 102 and another part extends outside the trench 102 and covers the gate dielectric layer 151 located on the first surface 10.

The trench gate structure 150 of the present embodiment extends from the inside of the trench 102 to the first surface 10, so as to protect the part of the first surface 10 adjacent to the trench 102, and reduce the damage of the first surface 10 adjacent to the trench 102 during the manufacturing process.

Alternatively, similar to the second embodiment of the present disclosure, the body contact region 140 and the source region 130 of the semiconductor device of the fifth embodiment may be separated.

Alternatively, the body contact area 140 of the semiconductor device of the fifth embodiment of the present disclosure may also be configured as in the third embodiment of the present disclosure. Along the Y-axis direction, a part of the body contact region 140 adjoins the second sidewall 150b of the trench gate structure 150, another part of the body contact region 140 has a space from the second sidewall 150b by the body region 110, so as to adjust characteristics related to the gate to source capacitance modulates.

Alternatively, the body contact area 140 of the semiconductor device of the fifth embodiment of the present disclosure may also be configured as in the fourth embodiment of the present disclosure. The edge of the channel drain region 120 facing toward the second surface 20 higher than the bottom surface of the trench gate structure 150, and the channel drain region 120 adjoins a part of the bottom surface 150c of the trench gate structure 150, so as to match depths of different trenches 102, injection time and injection dose of the channel drain region 120.

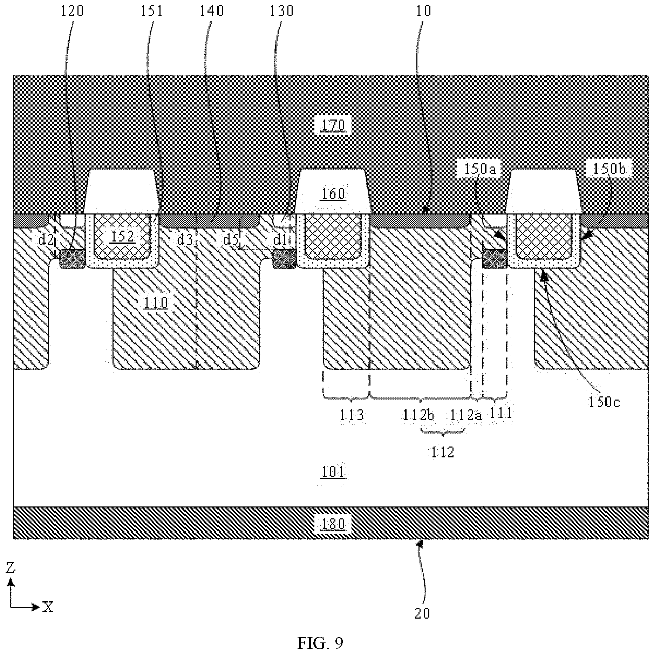

FIG. 9 is a schematic diagram of a semiconductor device according to a sixth embodiment of the present disclosure.

As shown in FIG. 9, the similarities between the semiconductor device of the sixth embodiment and the first embodiment will not be described here, with referring to FIGS. 1 to 3. The difference is that, in the present embodiment, the second part 112 of the body region 110 includes a first sub-region 112a and a second sub-region 112b that is connected. Along the X-axis direction, the first sub-region 112a adjoins the first part 111 of the body region 110, and the second sub-region 112b adjoins the third part 113 of the body region 110.

A distance from an edge of the first part 111 facing toward the second surface 20 to the first surface 10 is d5. A distance from an edge of the channel drain region 120 facing toward the second surface 20 to the first surface 10 is d1. A distance from an edge of the first sub-region 112a facing toward the second surface 20 to the first surface is d2. A distance from an edge of the second sub-region 112b facing toward the second surface 20 to the first surface 10 is d3. Wherein, d3> d1> d2> d5, so that the channel drain region 120 is separated from the second sub-region 112b by the drift region 101 along the X-axis direction.

In the present embodiment, by adjusting the distance d2 of a bottom edge of the first sub-region 112a to the first surface, an edge of the body region 110 close to the first sidewall 150a is stepped. In the direction along the first surface 10 to the second surface 20, the distance from the first sidewall 150a to the second part 112 of the body region 110 gradually increases. When the device is on, a current path of a current flow to the second surface 20 becomes wider after the current flows through the source region 130, the channel and the channel drain region 120, so as to reduce an on-resistance and further improve the performance of the device.

Alternatively, similar to the second embodiment of the present disclosure, the body contact region 140 and the source region 130 of the semiconductor device of the sixth embodiment may be separated.

Alternatively, the body contact area 140 of the semiconductor device of the sixth embodiment of the present disclosure may also be configured as in the third embodiment of the present disclosure. Along the Y-axis direction, a part of the body contact region 140 adjoins the second sidewall 150b of the trench gate structure 150, another part of the body contact region 140 has a space from the second sidewall 150b by the body region 110, so as to adjust characteristics related to the gate to source capacitance modulates.

Alternatively, the body contact area 140 of the semiconductor device of the sixth embodiment of the present disclosure may also be configured as in the fourth embodiment of the present disclosure. The edge of the channel drain region 120 facing toward the second surface 20 higher than the bottom surface of the trench gate structure 150, and the channel drain region 120 adjoins a part of the bottom surface 150c of the trench gate structure 150, so as to match depths of different trenches 102, injection time and injection dose of the channel drain region 120.

Alternatively, the trench gate structure of the semiconductor device of the sixth embodiment of the present disclosure may also be configured as in the fifth embodiment of the present disclosure. A part of the trench gate structure 150 is located in the trench 102, and another part is located above the first surface 10, so as to protect the first surface 10 adjacent to the trench 102.

The embodiment of the present disclosure is described above. However, these embodiments are intended solely for the purposes of illustration and not to limit the scope of the present disclosure. The scope of the present disclosure is defined by the attached claims and their equivalent. Without leaving the scope of the present disclosure, those skilled in the art may make a variety of alternatives and modifications, all of which shall fall within the scope of the present disclosure.

## Claims

1. A semiconductor device, comprising a semiconductor layer and a trench gate structure, wherein the semiconductor layer has a first surface and a second surface opposite to each other, the trench gate structure is at least partially located in a trench on the first surface of the semiconductor layer,
the semiconductor layer comprises:
a source region, extending from the first surface toward the second surface;
a drift region and a body region, wherein at least a part of the drift region is located between the body region and the second surface of the semiconductor layer, and the body region has a first part located between the source region and the drift region; and
a channel drain region, located between the first part of the body region and the drift region, so that the source region, the first part of the body region and the channel drain region are sequentially adjoining in a direction of the first surface toward the second surface and adjoin a first sidewall of the trench gate structure,
wherein the source region, the channel drain region, and the drift region are of a first conductivity type, the body region is of a second conductivity type, and the first conductivity type is opposite to the second conductivity type.

2. The semiconductor device according to claim 1, wherein a doping concentration of the channel drain region is greater than a doping concentration of the drift region.

3. The semiconductor device according to claim 1, wherein the first part, a second part and a third part of the body region are sequentially adjoining along a width direction of the trench gate structure,
the second part of the body region adjoins a second sidewall of the trench gate structure and the drift region, respectively,
the third part of the body region extends from a bottom surface of the trench gate structure toward the second surface and adjoins the drift region,
the channel drain region is separated from the third part of the body region by the drift region,
the first sidewall is opposite to the second sidewall.

4. The semiconductor device according to claim 3, wherein the second part of the body region comprises a first sub-region and a second sub-region that are connected,
the first sub-region adjoins the first part of the body region, the second sub-region adjoins the third part of the body region,
wherein a distance from an edge of the channel drain region facing toward the second surface to the first surface is a first distance,
a distance from an edge of the first sub-region facing toward the second surface to the first surface is a second distance,
a distance from an edge of the second sub-region facing toward the second surface to the first surface is a third distance,
the third distance is greater than the first distance, the first distance is greater than the second distance, so that the channel drain region is separated from the second sub-region by the drift region along the width direction of the trench gate structure.

5. The semiconductor device according to any one of claims 1 to 4, wherein edges of the second part and the third part of the body region facing toward the second surface are connected.

6. The semiconductor device according to any one of claims 1 to 4, wherein a distance from an edge of the channel drain region facing toward the second surface to the first surface is a first distance,
a distance from a bottom surface of the trench gate structure to the first surface is a fourth distance,
the first distance is not greater than the fourth distance.

7. The semiconductor device according to any one of claims 1 to 4, wherein a distance from an edge of the channel drain region facing toward the second surface to the first surface is a first distance,
a distance from a bottom surface of the trench gate structure to the first surface is a fourth distance,
the first distance is greater than the fourth distance, and the channel drain region adjoins a part of the bottom surface of the trench gate structure.

8. The semiconductor device according to claim 3 or 4, wherein the semiconductor layer further comprises a body contact region extending from the first surface toward the second surface and adjoins the body region,
wherein the body contact region is of the second conductivity type.

9. The semiconductor device according to claim 8, wherein along an extension direction of the trench gate structure, a part of the body contact region adjoins the second sidewall, another part of the body contact region has a space from the second sidewall, and the part of the body contact region adjoining the second sidewall and the part of the body contact having the space from the second sidewall are arranged alternatively along the extension direction of the trench gate structure,
or the body contact region is separated from the second surface by the body region.

10. The semiconductor device according to claim 8, wherein the body contact region adjoins the source region, or the body contact region is separated from the source region by the body region.

11. The semiconductor device according to any one of claims 1 to 4, wherein the trench gate structure comprises a gate dielectric layer and a gate conductor,
the gate dielectric layer covers an inner surface of the trench and covers part of first surface adjacent to the trench, the trench extending from the first surface toward the second surface,
a part of the gate conductor is in the trench, another part extends outside the trench and covers the gate dielectric layer,
wherein the gate dielectric layer is located between the gate conductor and the semiconductor layer, so as to separate the gate conductor and the semiconductor layer.

12. The semiconductor device according to claim 1, wherein the semiconductor layer comprises a SiC semiconductor layer.

13. The semiconductor device according to claim 1, wherein the semiconductor device is a metal-oxide semiconductor field effect transistor or an insulated gate bipolar transistor.

14. The semiconductor device according to claim 3 or 4, wherein between two trench gate structures, the source region extends from the first sidewall of one trench gate structure towards the second sidewall of the other trench gate structure, and adjoins the second part of the body region.
